# FASCICULE DE BREVET EUROPEEN

(11) **EP 2 612 157 B1**
(45) Date de publication et mention de la délivrance du brevet: **25.02.2015**
(21) Numéro de dépôt: 11749835.2
(22) Date de dépôt: 30.08.2011
(51) Int. Cl.: G01R 31/28, G01R 31/317, G01R 31/26, G01R 31/30

(54) **PROCEDE ET DISPOSITIF DE CONTROLE DE LATENCE DE CIRCUITS ELECTRONIQUES**
VERFAHREN UND VORRICHTUNG ZUR STEUERUNG DER LATENZ VON ELEKTRONISCHEN SCHALTUNGEN
METHOD AND DEVICE FOR CONTROLLING THE LATENCY OF ELECTRONIC CIRCUITS

(30) Priorité: 02.09.2010 FR 1056968
(43) Date de publication de la demande: 10.07.2013
(73) Titulaire: Commissariat à l'Énergie Atomique et aux Énergies Alternatives, 75015 Paris (FR)
(72) Inventeur: GHERMAN, Valentin, F-91300 Massy Palaiseau (FR); BONHOMME, Yannick, F-91650 Breuillet (FR)
(74) Mandataire: Dudouit, Isabelle
(86) Numéro de dépôt international: PCT/EP2011/064888
(87) Numéro de publication internationale: WO 2012/028608

(56) Documents cités:
- MRIDUL AGARWAL ET AL: "Circuit Failure Prediction and Its Application to Transistor Aging", VLSI TEST SYMMPOSIUM, 2007. 25TH IEEE, IEEE, PI, 1 mai 2007 (2007-05-01), pages 277-286, XP031091631, ISBN: 978-0-7695-2812-0
- KINNIMENT D J ET AL: "On-chip structures for timing measurement and test", MICROPROCESSORS AND MICROSYSTEMS, IPC BUSINESS PRESS LTD. LONDON, GB, vol. 27, no. 9, 1 octobre 2003 (2003-10-01), pages 473-483, XP004453319, ISSN: 0141-9331, DOI: DOI:10.1016/S0141-9331(03)00096-6
- MRIDUL AGARWAL ET AL: "Optimized Circuit Failure Prediction for Aging: Practicality and Promise", TEST CONFERENCE, 2008. ITC 2008. IEEE INTERNATIONAL, IEEE, PISCATAWAY, NJ, USA, 28 octobre 2008 (2008-10-28), pages 1-10, XP031372401, ISBN: 978-1-4244-2402-3

## Description

L'invention concerne un procédé et un dispositif pour le contrôle de latence de circuits électroniques utilisés par exemple pour le test des fautes de délai et des dispositifs apparentés qui s'appliquent notamment aux domaines des micro-technologies et des nanotechnologies. L'invention peut être utilisée, par exemple, pour la détection des fautes permanentes apparues lors de la phase de production des circuits ou dues au vieillissement de ces derniers.

Dans les circuits réalisés à base de micro-technologies et nanotechnologies, les fautes résultant de défauts physiques dus au vieillissement peuvent engendrer des erreurs de fonctionnement et finalement la défaillance du système. Une façon d'éviter ces défaillances est de masquer ou de corriger les erreurs. Le masquage peut être effectué, par exemple, à l'aide d'un vote majoritaire sur des systèmes redondants, tandis que d'habitude la correction se base sur une méthode de détection combinée avec des mécanismes de reconfiguration et de réexécution de l'opération défaillante. Malheureusement, le masquage et la correction ont des surcoûts importants notamment en matériel et en puissance.

Le coût de la « mitigation » des défauts physiques dus au vieillissement peut être diminué de façon significative si on considère que la majorité de ces défauts se manifestent à travers une augmentation progressive de la latence du circuit. Par conséquent, une approche moins onéreuse est de prévenir l'apparition des défaillances en détectant les éventuelles fautes de délai dues au vieillissement avant qu'elles ne génèrent des erreurs. Une technique de contrôle ou « monitoring » qui permet une détection par anticipation de ces fautes, consiste à tester les systèmes en mode dit "dégradé". Dans la présente description, le mot "dégradé" est défini comme une légère altération des paramètres du circuit pendant son test, ce terme étant connu de l'Homme du métier pour désigner un état de fonctionnement. Par exemple, la fréquence d'horloge d'un circuit synchrone peut être légèrement augmentée et/ou sa tension d'alimentation légèrement diminuée. Ce décalage entre les paramètres de fonctionnement en mode dégradé et en mode normal (non-dégradé) offre une marge temporelle pendant laquelle les fautes dues au vieillissement deviennent détectables avant de provoquer des erreurs en mode normal. Cette détection est équivalente à une anticipation des erreurs qui pourraient apparaître pendant le fonctionnement du circuit en mode normal (non-dégradé).

Dans les circuits actuels, ce type de dégradation est implémenté à l'aide de l'infrastructure qui permet la gestion de la tension d'alimentation et de la fréquence de travail.

Normalement, un système sur puce est partagé en plusieurs îlots de tension-fréquence, c'est-à-dire que chaque îlot a sa propre infrastructure matérielle pour la gestion de sa tension et de sa fréquence. Malheureusement la taille de ces îlots est relativement grande et ne permet pas le test en mode dégradé de certaines parties du circuit qui, épisodiquement, ne sont pas utilisées, pendant que d'autres parties du circuit dans le même îlot tension-fréquence exécutent des taches opératives. De plus la latence avec laquelle la tension d'alimentation et/ou la fréquence peuvent être changées est relativement faible et non adaptée à l'application du mode dégradé.

MRIDUL AGARWAL ET AL: "Circuit Failure Prediction and Its Application to Transistor Aging", VLSI TEST SYMMPOSIUM, 2007. 25TH IEEE, 1 mai 2007, pages 277-286, ISBN: 978-0-7695-2812-0 divulgue un capteur pour la prédiction de la défaillance par vieillissement des transistors.

L'invention concerne un dispositif de contrôle de la latence de circuits électroniques à base de micro-technologie et/ou de nanotechnologie, lesdits circuits à tester étant alimentés à l'aide d'une tension Vdd, ayant un niveau bas et un niveau haut, pour la détection de fautes de délai desdits circuits caractérisé en ce qu'il comporte en combinaison au moins un des éléments suivants :
- un dispositif de type I disposé entre le niveau haut Vdd de la tension d'alimentation et un ou plusieurs éléments du circuit à tester, et/ou
- un dispositif de type Il disposé entre le niveau bas Vss de la tension d'alimentation et un ou plusieurs éléments dudit circuit à tester,
- le dispositif de type I et le dispositif de type II comprenant au moins un chemin électrique de faible latence, ledit chemin de faible latence étant connecté en parallèle avec un chemin électrique de grande latence R,
- un signal de test contrôlant l'ouverture des chemins de faible latence tandis que les chemins électriques de grande latence sont ouverts.

Un dispositif de dégradation de type I est par exemple intercalé entre le niveau haut de la tension d'alimentation et un ou plusieurs éléments du circuit à tester et est constitué de trois transistors distribués de la manière suivante :
- un premier transistor offrant un chemin de faible latence ouvert seulement quand un signal de test T est assigné au niveau bas Vss de la tension d'alimentation, ledit premier transistor est fermé pendant le test du circuit en mode dégradé et ouvert pendant le fonctionnement en mode non-dégradé,
- un deuxième transistor toujours ouvert et offrant le chemin caractérisé par une grande latence,
- un troisième transistor utilisé pour générer à son drain D₂₃₃ la tension qui contrôle la grille G₂₃₂ du deuxième transistor.

Le dispositif comprend par exemple un dispositif de dégradation de type I intercalé entre le niveau haut de la tension d'alimentation et un ou plusieurs éléments du circuit à tester constitué :
- d'un premier transistor offrant un chemin de faible latence, ledit transistor étant ouvert seulement quand le signal de contrôle T est assigné au niveau bas Vss de la tension d'alimentation,
- un deuxième transistor toujours ouvert offrant un chemin caractérisé par une grande latence,
- le drain D₃₃₂ du transistor étant relié à sa propre grille G₃₃₂.

Un dispositif de dégradation de type I est, par exemple, intercalé entre le niveau haut de la tension d'alimentation et un ou plusieurs éléments du circuit à tester et comprend :
- un premier transistor offrant un chemin de faible latence, ledit premier transistor étant ouvert seulement quand le signal de contrôle (nT) est assigné au niveau haut Vdd de la tension d'alimentation,
- un deuxième transistor toujours ouvert et offrant un chemin caractérisé par une grande latence, la grille G₄₃₂ dudit transistor étant contrôlée par un signal Vcon ayant une tension électrique de niveau intermédiaire entre le niveau haut et le niveau bas de la tension d'alimentation.

Un dispositif de dégradation de type II peut être intercalé entre le niveau bas de la tension d'alimentation et un ou plusieurs éléments du circuit à tester comprenant:
- un premier transistor offrant un chemin de faible latence ouvert seulement quand le signal de contrôle (nT) est assigné au niveau haut Vdd de la tension d'alimentation,
- un deuxième transistor toujours ouvert et offrant un chemin caractérisé par une grande latence,
- un troisième transistor adapté pour générer à son drain D₅₄₃ la tension qui contrôle la grille G₅₄₂ du transistor.

Le dispositif peut comporter un dispositif de dégradation de type II contenant :
- un premier transistor offrant un chemin de faible latence ouvert quand le signal de contrôle (nT) est assigné au niveau haut Vdd de la tension d'alimentation,
- un deuxième transistor toujours ouvert et offrant un chemin caractérisé par une grande latence, le drain Dé42 du transistor est relié à sa propre grille G₆₄₂.

Le dispositif peut comporter un dispositif de dégradation de type II comprenant:
- un premier transistor offrant un chemin de faible latence ouvert quand le signal de contrôle nT est assigné au niveau haut Vdd de la tension d'alimentation,
- un deuxième transistor toujours ouvert et offrant un chemin caractérisé par une grande latence, la grille G₇₄₂ du transistor est contrôlée par un signal nVcon, la tension électrique appliquée par le signal nVcon ayant un niveau intermédiaire entre les niveaux haut Vdd et bas Vss de la tension d'alimentation.

Selon un mode de réalisation, le dispositif est composé d'une combinaison en série et/ou en parallèle des dispositifs de type I.

Selon un autre mode de réalisation le dispositif est composé d'une combinaison en série et/ou en parallèle des dispositifs de type II.

Le dispositif est utilisé, par exemple, pour le contrôle de la latence des bascules contenues dans le circuit à tester.

L'invention concerne aussi un procédé de contrôle de la latence des circuits électroniques à base de micro-technologie et/ou nanotechnologie, pour détecter des fautes dues au vieillissement ou à la phase de la production, caractérisé en ce qu'il utilise un dispositif présentant les caractéristiques décrites précédemment.

En dehors de la grande granularité temporelle et spatiale offerte pour le choix des modes dégradés, ces dispositifs se distinguent par un très faible coût matériel mesuré en nombre de transistors. De plus, les mêmes signaux de contrôle peuvent être utilisés pour piloter les dispositifs de dégradation du même type. Une simple inversion logique suffit pour assurer la conversion des signaux de contrôle entre les dispositifs de dégradation de type I et II.

D'autres caractéristiques et avantages de l'invention apparaîtront à l'aide de la description qui suit, donnée à titre illustratif et non limitatif et faite en regard des dessins annexés parmi lesquels:
- la figure 1 présente le procédé de dégradation proposé avec des dispositifs de dégradation selon l'invention de type I et II comportant un chemin de grande latence en parallèle avec un chemin de faible latence sélectionnable par un signal de contrôle;
- la figure 2 présente un dispositif de dégradation de type I dans lequel un premier transistor possédant une grille connectée au drain et à la grille d'un deuxième transistor constitue un chemin de grande latence ;
- la figure 3 présente un dispositif de dégradation de type I dans lequel le chemin de grande latence comprend un transistor ayant sa grille connectée à son drain;
- la figure 4 présente un dispositif de dégradation de type II où le chemin de grande latence comprend un transistor possédant une grille contrôlée par un signal permettant l'application d'une tension électrique avec un niveau intermédiaire entre les niveaux haut et bas de la tension d'alimentation du circuit à tester;
- la figure 5 présente un dispositif de dégradation de type II où le chemin de grande latence comprend un transistor dont la grille est connectée au drain et à la grille d'un autre transistor,
- la figure 6, un exemple de dispositif de dégradation de type II, dans lequel le chemin de grande latence comprend un transistor dans lequel la grille est connectée à son drain, et
- la figure 7, un exemple de dispositif de dégradation de type II dans lequel le chemin de grande latence comprend un transistor dont la grille est contrôlée par un signal qui permet l'application d'une tension électrique avec un niveau intermédiaire entre les niveaux haut et bas de la tension d'alimentation du circuit à tester.

L'une des idées de la présente invention est de disposer des dispositifs spécifiques, « DCS » en abrégé, soit entre les éléments du circuit à tester et le niveau haut de l'alimentation dudit circuit à tester, soit entre les éléments du circuit à tester et le niveau bas de l'alimentation dudit circuit. Ces dispositifs présentent notamment comme caractéristique de dégrader localement et temporairement la latence de circuits électroniques qui offrent au moins deux modes de fonctionnement, les modes dégradés et les modes normaux, présentant respectivement une grande et une faible latence qui dépendent de la technologie d'implémentation, des dimensions choisies pour les transistors utilisés dans le dispositif de dégradation et de la tension d'alimentation, elles pouvant aller, par exemple, de quelques picosecondes (virtuellement zéro) à l'infini. La grande latence est plus élevée que la faible latence. La suite de la description va donner quelques exemples :
- d'une part, de dispositif de dégradation de type I qui connectent des éléments du circuit au niveau haut de la tension d'alimentation Vdd,
- d'autre part, de dispositif de dégradation de type II qui connectent des éléments du circuit au niveau bas de la tension d'alimentation Vss.

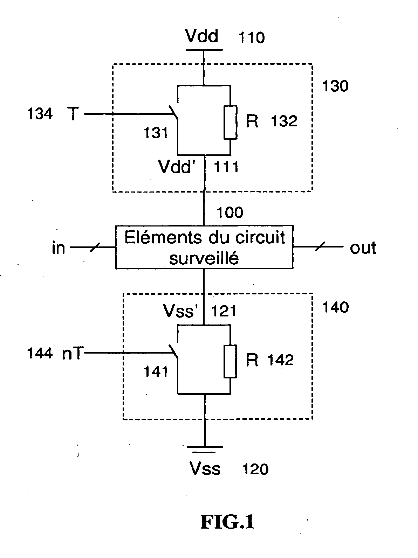

La figure 1 présente un exemple de réalisation de dispositif et de procédé de dégradation selon l'invention mettant en oeuvre des dispositifs de dégradation 130 et 140 respectivement de type I et II contenant un chemin de grande latence en parallèle avec un chemin faible latence pouvant être sélectionné par un signal de contrôle. L'alimentation du circuit à tester 100 est représentée par les éléments Vdd, 110 et Vss, 120 respectivement le niveau haut et le niveau bas du dispositif d'alimentation.

Les dispositifs de type I sont placés entre le niveau haut 110 (Vdd) de la tension d'alimentation et les éléments du circuit sous test 100 ou circuit à tester. Les dispositifs de type II sont placés entre le niveau bas 120 (Vss) de la tension d'alimentation et les mêmes ou autres éléments du circuit sous test 100. Les deux types de dispositifs de dégradation contiennent un chemin électrique de faible latence, 131 et respectivement 141, qui est connecté en parallèle avec un chemin électrique de grande latence (R), 132 et respectivement 142. L'ouverture des chemins de faible latence 131 et 141 est contrôlée par un signal de test 134 (T) respectivement 144 (nT) tandis que les chemins électriques de grande latence 132 et 142 sont toujours ouverts. Les chemins de faible latence sont fermés pendant le test du circuit en mode dégradé et ils sont ouverts pendant le fonctionnement en mode non-dégradé. Il n'est pas nécessaire que les deux types de dispositifs de dégradation soient appliqués aux mêmes éléments du circuit surveillé 100.

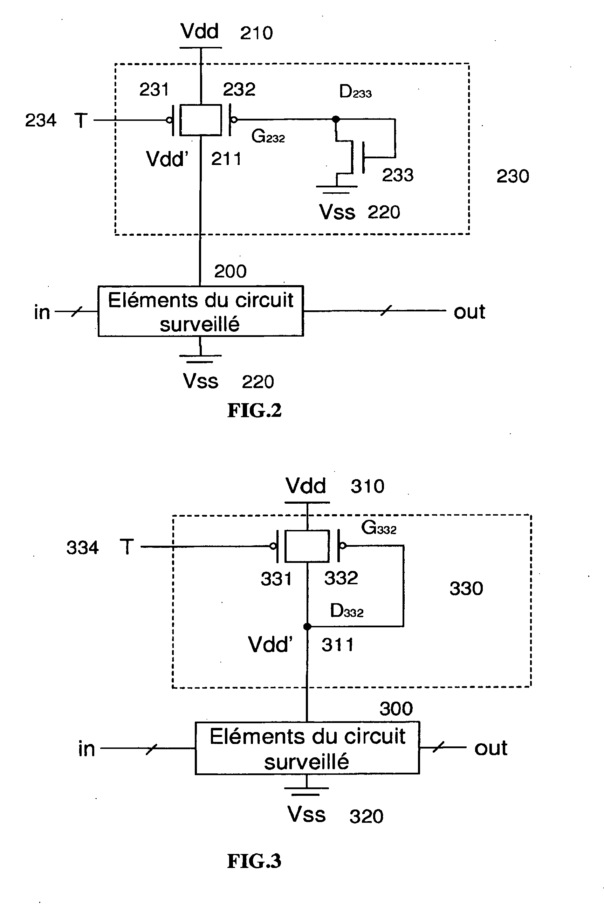

La figure 2 présente un dispositif de dégradation 230 de type I qui contient trois transistors. Le transistor 231 offre un chemin de faible latence qui est ouvert seulement quand le signal de contrôle 234 (T) est assigné au niveau bas 220 (Vss) de la tension d'alimentation. Le transistor 231 est fermé pendant le test du circuit en mode dégradé et il est ouvert pendant le fonctionnement en mode non-dégradé. Le transistor 232 est toujours ouvert et offre un chemin caractérisé par une grande latence. Le transistor 233 est utilisé pour générer à son drain D₂₃₃ la tension qui contrôle la grille G₂₃₂ du transistor 232. Cette tension est altérée, cela veut dire qu'elle a un niveau intermédiaire entre le niveau bas 220 (Vss) de la tension d'alimentation et la tension de commutation du transistor 232. La tension altérée induit une latence élevée du transistor 232. Le dispositif 230 peut être intercalé entre le niveau haut 210 (Vdd) de la tension d'alimentation et un ou plusieurs éléments du circuit à tester 200 (des cellules standard par exemple) qui sont reliés au noeud 211 (Vdd') à la place du noeud 210 (Vdd).

La figure 3 présente un dispositif de dégradation 330 de type I qui contient deux transistors. Le transistor 331 offre un chemin de faible latence qui est ouvert seulement quand le signal de contrôle 334 (T) est assigné au niveau bas 320 (Vss) de la tension d'alimentation. Le transistor 331 est fermé pendant le test du circuit en mode dégradé et il est ouvert pendant le fonctionnement en mode non-dégradé. Le transistor 332 est toujours ouvert et offre un chemin caractérisé par une grande latence. Le drain D₃₃₂ du transistor 332 est relié à sa propre grille G₃₃₂. Par conséquent, la tension qui contrôle la grille du transistor 332 est altérée, cela veut dire qu'elle a un niveau intermédiaire entre le niveau bas 320 (Vss) de la tension d'alimentation et la tension de commutation du transistor 332. Cette tension altérée induit une latence élevée du transistor 332. Le dispositif 330 peut être intercalé entre le niveau haut 310 (Vdd) de la tension d'alimentation et un ou plusieurs éléments du circuit sous test 300 (des cellules standard par exemple) qui sont reliés au noeud 311 (Vdd') à la place du noeud 310 (Vdd).

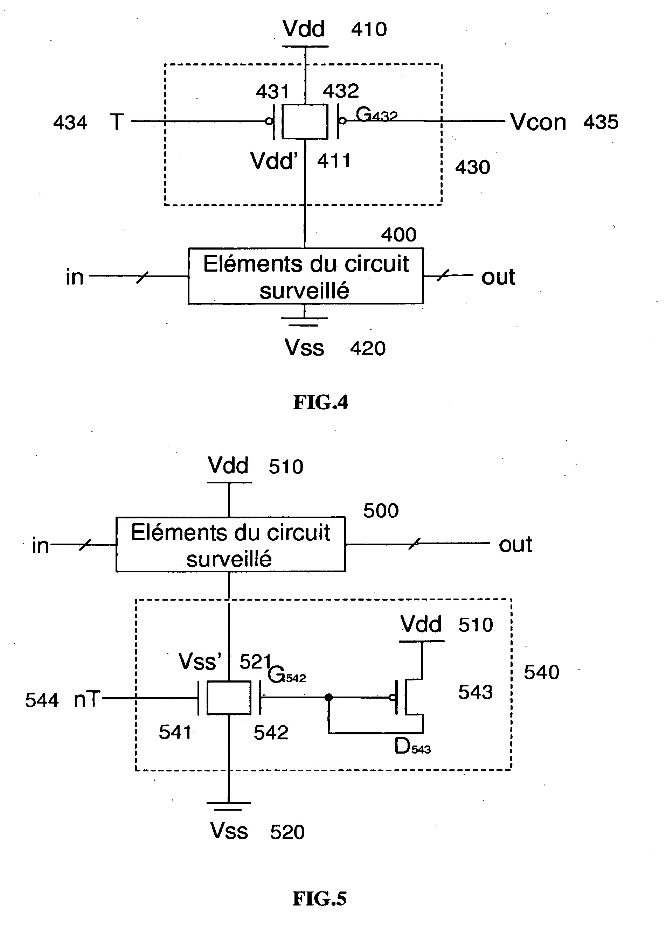

La figure 4 présente un dispositif de dégradation 430 de type I qui contient deux transistors 431, 432. Le transistor 431 offre un chemin de faible latence qui est ouvert seulement quand le signal de contrôle 434 (T) est assigné au niveau bas 420 (Vss) de la tension d'alimentation. Le transistor 431 est fermé pendant le test du circuit en mode dégradé et il est ouvert pendant le fonctionnement en mode normal (non-dégradé). Le transistor 432 est toujours ouvert et offre un chemin caractérisé par une grande latence. La grille G₄₃₂ du transistor 432 est contrôlée par un signal Vcon (435). La tension électrique appliquée par le signal Vcon (435) a un niveau intermédiaire entre le niveau bas 420 (Vss) de la tension d'alimentation et la tension de commutation du transistor 432. Ce niveau intermédiaire permet un contrôle fin de la latence du transistor 432 et peut être choisi pendant un processus de caractérisation des circuits à tester ou de la technologie utilisée pour la production de ces circuits. Le dispositif 430 peut être intercalé entre le niveau haut 410 (Vdd) de la tension d'alimentation et un ou plusieurs éléments du circuit sous test 400 (des cellules standard par exemple) qui sont reliés au noeud 411 (Vdd') à la place du noeud 410 (Vdd).

La figure 5 présente un dispositif de dégradation 540 de type II qui contient trois transistors 541, 542, 543. Le transistor 541 offre un chemin de faible latence qui est ouvert seulement quand un signal de contrôle 544 (nT) est assigné au niveau haut 510 (Vdd) de la tension d'alimentation. Le transistor 541 est fermé pendant le test du circuit en mode dégradé et il est ouvert pendant le fonctionnement en mode non-dégradé. Le transistor 542 est toujours ouvert et offre un chemin caractérisé par une grande latence. Le transistor 543 est utilisé pour générer à son drain D₅₄₃ la tension qui contrôle la grille G₅₄₂ du transistor 542. Cette tension est altérée, cela veut dire qu'elle a un niveau intermédiaire entre le niveau haut 510 (Vdd) de la tension d'alimentation et la tension de commutation du transistor 542. Cette tension altérée induit une latence élevée du transistor 542. Le dispositif 540 peut être intercalé entre le niveau bas 520 (Vss) de la tension d'alimentation et un ou plusieurs éléments du circuit sous test 500 (des cellules standard par exemple) qui sont reliés au noeud 521 (Vss') à la place du noeud 520 (Vss).

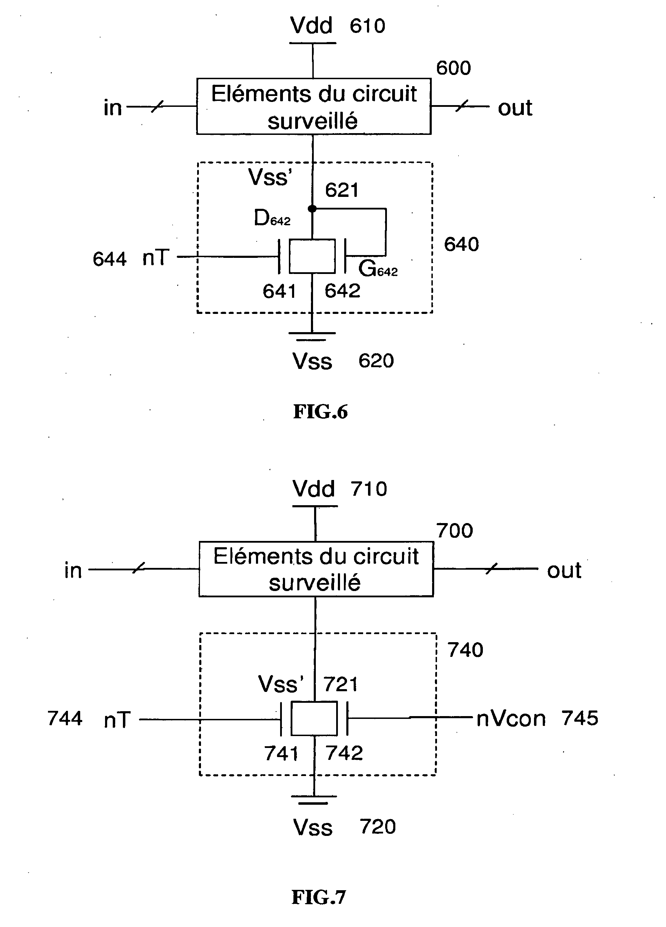

La figure 6 présente un dispositif de dégradation 640 de type II qui contient deux transistors. Le transistor 641 offre un chemin de faible latence qui est ouvert seulement quand le signal de contrôle 644 (nT) est assigné au niveau haut 610 (Vdd) de la tension d'alimentation. Le transistor 641 est fermé pendant le test du circuit en mode dégradé et il est ouvert pendant le fonctionnement en mode non-dégradé. Le transistor 642 est toujours ouvert et offre un chemin caractérisé par une grande latence. Le drain D₆₄₂ du transistor 642 est relié à sa propre grille G₆₄₂. Par conséquent, la tension qui contrôle la grille G₆₄₂ du transistor 642 est altérée, cela veut dire qu'elle a un niveau intermédiaire entre le niveau haut 610 (Vdd) de la tension d'alimentation et la tension de commutation du transistor 642. Cette tension altérée induit une latence élevée du transistor 642. Le dispositif 640 peut être intercalé entre le niveau bas 620 (Vss) de la tension d'alimentation et un ou plusieurs éléments du circuit sous test 600 (des cellules standard par exemple) qui sont reliés au noeud 621 (Vss') à la place du noeud 620 (Vss).

La figure 7 présente un dispositif de dégradation 740 de type II qui contient deux transistors. Le transistor 741 offre un chemin de faible latence qui est ouvert seulement quand le signal de contrôle 744 (nT) est assigné au niveau haut 710 (Vdd) de la tension d'alimentation. Le transistor 741 est fermé pendant le test du circuit en mode dégradé et il est ouvert pendant le fonctionnement en mode normal (non-dégradé). Le transistor 742 est toujours ouvert et offre un chemin caractérisé par une grande latence. La grille G₇₄₂ du transistor 742 est contrôlée par un signal nVcon (745). La tension électrique appliquée par le signal nVcon (745) a un niveau intermédiaire entre le niveau haut 710 (Vdd) de la tension d'alimentation et la tension de commutation du transistor 742. Ce niveau intermédiaire permet un contrôle fin de la latence du transistor 742 et peut être choisi pendant un processus de caractérisation des circuits à tester ou de la technologie utilisée pour la production de ces circuits. Le dispositif 740 peut être intercalé entre le niveau bas 720 (Vss) de la tension d'alimentation et un ou plusieurs éléments du circuit sous test 700 (des cellules standard par exemple) qui sont reliés au noeud 721 (Vss') à la place du noeud 720 (Vss).

Si les dispositifs de dégradation 230, 330, 430, 540, 640 ou 740 sont choisis seulement pour leurs grandes granularités temporelle et spatiale, comme dans le cas du test en ligne concurrent, alors ils peuvent être appliqués seulement aux bascules (en anglais "flip-flops" ou "latches") du circuit sous test. Par contre, dans le cas où ces dispositifs sont utilisés seulement pour leurs caractéristiques intrinsèques de dégradation, c'est à dire le fait d'agir sur l'impédance du circuit sous test, il est préférable que ces dispositifs affectent tous les éléments du circuit. Le dernier cas concerne les tests non-concurrents comme le test de production utilisé pour filtrer les circuits avec des défauts de jeunesse et les tests périodiques utilisés pour le monitoring des systèmes dans leurs environnements d'exploitation.

Les dispositifs de même type de dégradation (I ou II) peuvent être combinés en série ou en parallèle pour réaliser le contrôle de la latence de circuits électroniques pour le test des fautes de délai. Les mêmes signaux de contrôle peuvent être utilisés pour choisir la latence des dispositifs qui produisent le même type de dégradation (I ou II) et doivent être appliqués au même type de test (concurrent ou non-concurrent). Une simple inversion logique (nT = not T) suffit pour assurer la conversion des signaux de contrôle entre les dispositifs de dégradation de type I et II.

Le procédé et le dispositif selon l'invention offrent une grande granularité temporelle et spatiale dans le choix des circuits qui peuvent être testés en mode dégradé de façon concurrente, c'est à dire en parallèle avec le fonctionnent normal du reste du système. L'un des objectifs de la présente demande de brevet est de pouvoir tester en mode dégradé plus souvent les circuits non-utilisés pendant certaines périodes de temps. L'idée est d'insérer des structures spéciales avec une latence contrôlable entre les points du réseau d'alimentation électrique et la totalité ou une partie des éléments des circuits sous test comme il a été décrit. Les grandes latences sont choisies pour les modes dégradés tandis que les faibles latences pendant les modes normaux (non-dégradées) de fonctionnement.

Un autre avantage de ce procédé et du dispositif associé est qu'ils offrent une nouvelle manière de procéder utilisable pendant les tests non-concurrents des circuits quand les granularités temporelle et spatiale de la dégradation ne sont pas critiques, comme par exemple pendant les tests de production ou les tests périodiques utilisés pour le monitoring des circuits dans leurs environnements d'exploitation. Normalement après leur production, les circuits sont stressés en les faisant travailler à des tensions et des températures plus élevées que celles prévues pour leur fonctionnement normal. En anglais, ce type de stress est connu sur la dénomination de "burn-in". Une alternative au burn-in est le test à une tension d'alimentation plus faible que la tension de fonctionnement normal. Cela peut être vu comme une forme de dégradation. Avec la présente invention, une autre forme de dégradation devient possible qui est complémentaire à la baisse de la tension d'alimentation. Cette forme de dégradation est caractérisée par une augmentation locale de l'impédance et une limitation du courant d'alimentation des éléments du circuit reliés aux dispositifs proposés et décrits ci-après.

## Revendications

1. Dispositif de contrôle de la latence de circuits électroniques à base de micro-technologie et/ou nanotechnologie, lesdits circuits à tester (100) étant alimentés à l'aide d'une tension Vdd, ayant un niveau bas et un niveau haut, pour la détection de fautes de délai desdits circuits **caractérisé en ce qu'**il comporte en combinaison au moins un des éléments suivants :
• un dispositif de type I disposé entre le niveau haut (110) (Vdd) de la tension d'alimentation et un ou plusieurs éléments du circuit (100) à tester, et/ou
• un dispositif de type II disposé entre le niveau bas (120) Vss de la tension d'alimentation et un ou plusieurs éléments dudit circuit à tester (100),
• le dispositif de type I et le dispositif de type II comprenant au moins un chemin électrique de faible latence, (131,141), ledit chemin de faible latence étant connecté en parallèle avec un chemin électrique de grande latence R, (132,142),
• un signal de test (134, 144) contrôlant l'ouverture des chemins de faible latence (131, 141) tandis que les chemins électriques de grande latence (132, 142) sont ouverts.

2. Dispositif selon la revendication 1 **caractérisé en ce qu'**un dispositif de dégradation de type I (230) intercalé entre le niveau haut (210) de la tension d'alimentation et un ou plusieurs éléments du circuit à tester est constitué de trois transistors distribués de la manière suivante :
• un premier transistor (231) offrant un chemin de faible latence ouvert seulement quand un signal de test T (234) est assigné au niveau bas Vss (220) de la tension d'alimentation, ledit premier transistor (231) est fermé pendant le test du circuit en mode dégradé et ouvert pendant le fonctionnement en mode non-dégradé,
• un deuxième transistor (232) toujours ouvert et offrant le chemin **caractérisé par** une grande latence,
• un troisième transistor (233) utilisé pour générer à son drain D₂₃₃ la tension qui contrôle la grille G₂₃₂ du deuxième transistor (232).

3. Dispositif selon la revendication 1 **caractérisé en ce qu'**il comporte un dispositif de dégradation (330) de type I intercalé entre le niveau haut (310) de la tension d'alimentation et un ou plusieurs éléments du circuit à tester constitué :
• d'un premier transistor (331) offrant un chemin de faible latence, ledit transistor (331) étant ouvert seulement quand le signal de contrôle (334) est assigné au niveau bas Vss (320) de la tension d'alimentation,
• un deuxième transistor (332) toujours ouvert offrant un chemin **caractérisé par** une grande latence,
• le drain D₃₃₂ du transistor (332) étant relié à sa propre grille G₃₃₂.

4. Dispositif selon la revendication 1 **caractérisé en ce qu'**un dispositif de dégradation (430) de type I intercalé entre le niveau haut (410) de la tension d'alimentation et un ou plusieurs éléments du circuit à tester comprend :
• un premier transistor (431) offrant un chemin de faible latence, ledit premier transistor étant ouvert seulement quand le signal de contrôle nT (434) est assigné au niveau haut Vdd (420) de la tension d'alimentation,
• un deuxième transistor (432) toujours ouvert et offrant un chemin **caractérisé par** une grande latence, la grille G₄₃₂ dudit transistor étant contrôlée par un signal Vcon ayant une tension électrique de niveau intermédiaire entre le niveau haut (410) et le niveau bas (420) de la tension d'alimentation.

5. Dispositif selon la revendication 1 **caractérisé en ce qu'**un dispositif de dégradation (540) de type II intercalé entre le niveau bas (520) de la tension d'alimentation et un ou plusieurs éléments du circuit à tester (100) comprend:
• un premier transistor (541) offrant un chemin de faible latence ouvert seulement quand le signal de contrôle nT (544) est assigné au niveau haut Vdd (520) de la tension d'alimentation,
• un deuxième transistor (542) toujours ouvert et offrant un chemin **caractérisé par** une grande latence,
• un troisième transistor (543) adapté pour générer à son drain D₅₄₃ la tension qui contrôle la grille G₅₄₂ du transistor (542).

6. Dispositif selon la revendication 1 **caractérisé en ce qu'**il comprend un dispositif de dégradation (640) de type II contenant :
• un premier transistor (641) offrant un chemin de faible latence ouvert quand le signal de contrôle nT (644) est assigné au niveau haut (610) (Vdd) de la tension d'alimentation,
• un deuxième transistor (642) toujours ouvert et offrant un chemin **caractérisé par** une grande latence, le drain D₆₄₂ du transistor (642) est relié à sa propre grille G₆₄₂.

7. Dispositif selon la revendication 1 **caractérisé en ce qu'**il comporte un dispositif de dégradation (740) de type II comprenant:
• un premier transistor (741) offrant un chemin de faible latence ouvert quand le signal de contrôle nT (744) est assigné au niveau haut (710) (Vdd) de la tension d'alimentation,
• un deuxième transistor (742) toujours ouvert et offrant un chemin **caractérisé par** une grande latence, la grille du transistor (742) est contrôlée par un signal nVcon (745), la tension électrique appliquée par le signal nVcon (745) ayant un niveau intermédiaire entre les niveaux haut Vdd (710) et bas Vss (720) de la tension d'alimentation.

8. Dispositif selon l'une des revendications 2 à 4 **caractérisé en ce qu'**il est composé d'une combinaison en série et/ou en parallèle des dispositifs de type I.

9. Dispositif selon l'une des revendications 5 à 7 **caractérisé en ce qu'**il est composé d'une combinaison en série et/ou en parallèle des dispositifs de type II.

10. Utilisation du dispositif selon l'une des revendications 1 à 9 pour le contrôle de la latence des bascules contenues dans le circuit à tester.

11. Procédé de contrôle de la latence des circuits électroniques à base de micro-technologie et/ou nanotechnologie, pour détecter des fautes dues au vieillissement ou à la phase de la production, **caractérisé en ce qu'**il utilise un dispositif selon l'une des revendications 1 à 10.

## Patentansprüche

1. Vorrichtung zum Regeln der Latenz von elektronischen Schaltungen auf der Basis von Mikrotechnologie und/oder Nanotechnologie, wobei die zu prüfenden Schaltungen (100) mit einer Spannung Vdd mit einem tiefen Pegel und einem hohen Pegel gespeist werden, zum Erkennen von zeitlichen Fehlern der Schaltungen, **dadurch gekennzeichnet, dass** sie in Kombination wenigstens eines der folgenden Elemente umfasst:
• eine Vorrichtung des Typs I, geschaltet zwischen dem hohen Pegel (110) (Vdd) der Speisespannung und einem oder mehreren zu prüfenden Elementen der Schaltung (100), und/oder
• eine Vorrichtung des Typs II, geschaltet zwischen dem tiefen Pegel (120) (Vss) der Speisespannung und einem oder mehreren zu prüfenden Elementen der Schaltung (100),
• wobei die Vorrichtung des Typs I und die Vorrichtung des Typs II wenigstens einen niederlatenten elektrischen Pfad (131, 141) umfassen, wobei der niederlatente Pfad mit einem elektrischen Pfad mit hoher Latenz R (132, 142) parallelgeschaltet ist,
• wobei ein Prüfsignal (134, 144) das Öffnen der niederlatenten Pfade (131, 141) steuert, während die hochlatenten elektrischen Pfade (132, 142) offen sind.

2. Vorrichtung nach Anspruch 1, **dadurch gekennzeichnet, dass** eine Minderungsvorrichtung des Typs I (230), geschaltet zwischen dem hohen Pegel (210) der Speisespannung und einem oder mehreren Elementen der zu prüfenden Schaltung, von drei Transistoren gebildet wird, die wie folgt verteilt sind:
• ein erster Transistor (231), der einen niederlatenten Pfad bietet, der nur dann offen ist, wenn ein Prüfsignal T (234) mit dem tiefen Pegel Vss (220) der Speisespannung angelegt wird, wobei der erste Transistor (231) während der Prüfung der Schaltung im geminderten Modus geschlossen und während des Betriebs im nichtgeminderten Modus offen ist,
• ein zweiter Transistor (232), der immer offen ist und den durch eine hohe Latenz charakterisierten Pfad bietet,
• ein dritter Transistor (233), an dessen Drain D₂₃₃ die Spannung erzeugt wird, die das Gate G₂₃₂ des zweiten Transistors (232) steuert.

3. Vorrichtung nach Anspruch 1, **dadurch gekennzeichnet, dass** sie eine Minderungsvorrichtung (330) des Typs I umfasst, die zwischen dem hohen Pegel (310) der Speisespannung und einem oder mehreren Elementen der zu prüfenden Schaltung geschaltet ist, gebildet durch:
• einen ersten Transistor (331), der einen niederlatenten Pfad bietet, wobei der Transistor (331) nur dann offen ist, wenn das Steuersignal (334) mit dem tiefen Pegel Vss (320) der Speisespannung angelegt wird,
• einen zweiten Transistor (332), der immer offen ist und einen durch eine hohe Latenz charakterisierten Pfad bietet,
• wobei der Drain D₃₃₂ des Transistors (332) mit seinem eigenen Gate G₃₃₂ verbunden ist.

4. Vorrichtung nach Anspruch 1, **dadurch gekennzeichnet, dass** eine Minderungsvorrichtung (430) des Typs I, geschaltet zwischen dem hohen Pegel (410) der Speisespannung und einem oder mehreren Elementen der zu prüfenden Schaltung, Folgendes umfasst:
• einen ersten Transistor (431), der einen niederlatenten Pfad bietet, wobei der erste Transistor nur dann offen ist, wenn das Steuersignal nT (434) mit dem hohen Pegel Vdd (420) der Speisespannung angelegt wird,
• einen zweiten Transistor (432), der immer offen ist und einen durch eine hohe Latenz gekennzeichneten Pfad bietet, wobei das Gate G₄₃₂ des Transistors durch ein Signal Vcon mit einer elektrischen Spannung mit einem Zwischenpegel zwischen dem hohen Pegel (410) und dem tiefen Pegel (420) der Speisespannung gesteuert wird.

5. Vorrichtung nach Anspruch 1, **dadurch gekennzeichnet, dass** eine Minderungsvorrichtung (540) des Typs II, geschaltet zwischen dem tiefen Pegel (520) der Speisespannung und einem oder mehreren Elementen der zu prüfenden Schaltung (100), Folgendes umfasst:
• einen ersten Transistor (541), der einen niederlatenten Pfad bietet, der nur dann offen ist, wenn das Steuersignal nT (544) an den hohen Pegel Vdd (520) der Speisespannung angelegt wird,
• einen zweiten Transistor (542), der immer offen ist und einen durch eine hohe Latenz gekennzeichneten Pfad bietet,
• einen dritten Transistor (543), an dessen Drain D₅₄₃ die Spannung erzeugt wird, die das Gate G₅₄₂ des Transistors (542) steuert.

6. Vorrichtung nach Anspruch 1, **dadurch gekennzeichnet, dass** sie eine Minderungsvorrichtung (640) des Typs II umfasst, die Folgendes umfasst:
• einen ersten Transistor (641), der einen niederlatenten Pfad bietet, der offen ist, wenn das Steuersignal nT (644) mit dem hohen Pegel (610) (Vdd) der Speisespannung angelegt wird,
• einen zweiten Transistor (642), der immer offen ist und einen durch eine hohe Latenz gekennzeichneten Pfad bietet, wobei der Drain D₆₄₂ des Transistors (642) mit seinem eigenen Gate G₆₄₂ verbunden ist.

7. Vorrichtung nach Anspruch 1, **dadurch gekennzeichnet, dass** sie eine Minderungsvorrichtung (740) des Typs II umfasst, die Folgendes beinhaltet:
• einen ersten Transistor (741), der einen niederlatenten Pfad bietet, der offen ist, wenn das Steuersignal nT (744) mit dem hohen Pegel (710) (Vdd) der Speisespannung angelegt wird,
• einen zweiten Transistor (742), der immer offen ist und einen durch eine hohe Latenz gekennzeichneten Pfad bietet, wobei das Gate des Transistors (742) durch ein Signal nVcon (745) gesteuert wird, wobei die durch das Signal nVcon (745) angelegte elektrische Spannung einen Zwischenpegel zwischen dem hohen Pegel Vdd (710) und dem tiefen Pegel Vss (720) der Speisespannung hat.

8. Vorrichtung nach einem der Ansprüche 2 bis 4, **dadurch gekennzeichnet, dass** sie aus einer seriellen und/oder parallelen Kombination von Verrichtungen des Typs I zusammengesetzt ist.

9. Vorrichtung nach einem der Ansprüche 5 bis 7, **dadurch gekennzeichnet, dass** sie aus einer seriellen und/oder parallelen Kombination der Vorrichtungen des Typs II zusammengesetzt ist.

10. Verwendung der Vorrichtung nach einem der Ansprüche 1 bis 9 zum Regeln der Latenz von Flipflops, die in der zu prüfenden Schaltung enthalten sind.

11. Verfahren zum Regeln der Latenz von elektronischen Schaltungen auf der Basis von Mikrotechnologie und/oder Nanotechnologie zum Erkennen von Fehlern aufgrund von Alterung oder aufgrund der Phase der Produktion, **dadurch gekennzeichnet, dass** es eine Vorrichtung nach einem der Ansprüche 1 bis 10 benutzt.

## Claims

1. A device for monitoring the latency of electronic circuits based on microtechnology and/or nanotechnology, said circuits (100) to be tested being supplied with the aid of a voltage Vdd, having a low level and a high level, for the detection of delay faults of said circuits, **characterized in that** it comprises in combination at least one of the following elements:
• a device of type I placed between the high level (110) (Vdd) of the power supply voltage and one or more elements of the circuit (100) to be tested, and/or
• a device of type II placed between the low level (120) Vss of the power supply voltage and one or more elements of said circuit (100) to be tested,
• the device of type I and the device of type II comprising at least one low-latency electrical path (131,141), said low-latency path being connected in parallel with a high-latency electrical path R, (132,142),
• a test signal (134, 144) monitoring the opening of the low-latency paths (131, 141) while the high-latency electrical paths (132, 142) are open.

2. The device as claimed in claim 1, **characterized in that** a degradation device of type I (230) inserted between the high level (210) of the power supply voltage and one or more elements of the circuit to be tested consists of three transistors distributed in the following manner:
• a first transistor (231) offering a low-latency path that is open only when a test signal T (234) is assigned to the low level Vss (220) of the power supply voltage, said first transistor (231) is closed during the test of the circuit in degraded mode and open during operation in nondegraded mode,
• a second transistor (232) that is always open and offering the path **characterized by** a high latency,
• a third transistor (233) used to generate at its drain D₂₃₃ the voltage that controls the gate G₂₃₂ of the second transistor (232).

3. The device as claimed in claim 1, **characterized in that** it comprises a degradation device (330) of type I inserted between the high level (310) of the power supply voltage and one or more elements of the circuit to be tested consisting:
• of a first transistor (331) offering a low-latency path, said transistor (331) being open only when the monitoring signal (334) is assigned to the low level Vss (320) of the power supply voltage,
• a second transistor (332) that is always open offering a path **characterized by** a high latency,
• the drain D₃₃₂ of the transistor (332) being connected to its own gate G₃₃₂.

4. The device as claimed in claim 1, **characterized in that** a degradation device (430) of type I inserted between the high level (410) of the power supply voltage and one or more elements of the circuit to be tested comprises:
• a first transistor (431) offering a low-latency path, said first transistor being open only when the monitoring signal nT (434) is assigned to the high level Vdd (420) of the power supply voltage,
• a second transistor (432) that is always open and offering a path **characterized by** a high latency, the gate G₄₃₂ of said transistor being monitored by a signal Vcon having an electrical voltage of intermediate level between the high level (410) and the low level (420) of the power supply voltage.

5. The device as claimed in claim 1, **characterized in that** a degradation device (540) of type II inserted between the low level (520) of the power supply voltage and one or more elements of the circuit (100) to be tested comprises:
• a first transistor (541) offering a low-latency path that is open only when the monitoring signal nT (544) is assigned to the high level Vdd (520) of the power supply voltage,
• a second transistor (542) that is always open and offering a path **characterized by** a high latency,
• a third transistor (543) adapted to generate at its drain D₅₄₃ the voltage that controls the gate G₅₄₂ of the transistor (542).

6. The device as claimed in claim 1, **characterized in that** it comprises a degradation device (640) of type II containing:
• a first transistor (641) offering a low-latency path that is open when the monitoring signal nT (644) is assigned to the high level (610) (Vdd) of the power supply voltage,
• a second transistor (642) that is always open and offering a path **characterized by** a high latency, the drain D₆₄₂ of the transistor (642) is connected to its own gate G₆₄₂.

7. The device as claimed in claim 1, **characterized in that** it comprises a degradation device (740) of type II comprising:
• a first transistor (741) offering a low-latency path that is open when the monitoring signal nT (744) is assigned to the high level (710) (Vdd) of the power supply voltage,
• a second transistor (742) that is always open and offering a path **characterized by** a high latency, the gate of the transistor (742) is monitored by a signal nVcon (745), the electrical voltage applied by the signal nVcon (745) having an intermediate level between the high level Vdd (710) and the low level Vss (720) of the power supply voltage.

8. The device as claimed in one of claims 2 to 4, **characterized in that** it consists of a combination in series and/or in parallel of the devices of type I.

9. The device as claimed in one of claims 5 to 7, **characterized in that** it consists of a combination in series and/or in parallel of the devices of type II.

10. The use of the device as claimed in one of claims 1 to 9 for monitoring the latency of the flip-flops contained in the circuit to be tested.

11. A method for monitoring the latency of the electronic circuits based on microtechnology and/or nanotechnology, in order to detect faults due to burning-in or to the production phase, **characterized in that** it uses a device as claimed in one of claims 1 to 10.
